# EUROPÄISCHE PATENTSCHRIFT

(11) **EP 2 044 449 B1**
(45) Veröffentlichungstag und Bekanntmachung des Hinweises auf die Patenterteilung: **30.03.2011**
(21) Anmeldenummer: 07764350.0
(22) Anmeldetag: 01.06.2007
(51) Int. Cl.: G01R 31/04, G01R 1/067

(54) **PRÜFSTIFT FÜR EINE PRÜFVORRICHTUNG ZUM PRÜFEN VON STECKERN UND VERFAHREN ZUM PRÜFEN VON STECKERN**
TEST PROBE FOR A TEST APPARATUS FOR TESTING PLUG-TYPE CONNECTORS AND METHOD FOR TESTING PLUG-TYPE CONNECTORS
POINTE DE TOUCHE POUR UN DISPOSITIF DE CONTRÔLE DE FICHES ET PROCÉDÉ DE CONTRÔLE DE FICHES

(30) Priorität: 02.06.2006 DE 102006025850
(43) Veröffentlichungstag der Anmeldung: 08.04.2009
(73) Patentinhaber: TSK Prüfsysteme GmbH, 32457 Porta Westfalica (DE)
(72) Erfinder: STENGEL, Jürgen, 31707 Heessen (DE); ROMMELMANN, Reiner, 32427 Minden (DE)
(74) Vertreter: Bremer, Ulrich
(86) Internationale Anmeldenummer: PCT/DE2007/000989
(87) Internationale Veröffentlichungsnummer: WO 2007/140753

(56) Entgegenhaltungen:
- EP-A- 1 209 777
- DE-U1- 9 411 164
- DE-U1- 20 008 214
- GB-A- 2 170 962
- US-B1- 7 030 636

## Beschreibung

Die Erfindung betrifft einen Prüfstift für eine Prüfvorrichtung zum Prüfen von Steckern gemäß dem Oberbegriff von Anspruch 1 sowie eine Prüfvorrichtung unter Verwendung eines Prüfstiftes sowie ein Verfahren zum Prüfen von Steckern.

Eine derartige Prüfvorrichtung ist aus der DE 35 04 606 C2 bekannt und dient insbesondere zur Prüfung, ob in den Steckern eines Kabelbaums die Steckerkontakte ordnungsgemäß verrastet sind. Hierzu weist die Prüfvorrichtung eine Adapterplatte mit einer Kontur zur Aufnahme des zu prüfenden Steckers auf, wobei der in die Kontur eingesetzte Stecker durch mindestens einen pneumatischen Haltezylinder fixiert wird. Weiterhin ist eine verschiebbare Ebene mit eingesetzten Prüfstiften vorgesehen, die gegen die Adapterplatte mit dem aufgenommenen Stecker verfahren wird. Die Prüfstifte weisen jeweils eine Prüfnadel auf, die mit einer vorgegebenen Federkraft gegen jeweils einen Steckerkontakt des zu prüfenden Steckers drücken. Bei einer ordnungsgemäßen Verrastung des Steckerkontaktes im Steckergehäuse wird dieser nicht verschoben und die Prüfnadel (Federkontakt) gegen ihre Federvorspannung in dem Prüfstift eingedrückt. Bei fehlerhafter Verrastung kann die Prüfnadel den Steckerkontakt in dem Steckergehäuse nach hinten eindrücken. Somit kann die Verschiebung der Prüfnadel relativ zu der verfahrbaren Ebene gemessen werden, um Aussagen über die ordnungsgemäβe Verrastung der Steckerkontakte im Steckergehäuse zu erhalten.

Zur Sensierung bzw. Messung der Prüfnadeln ist gemäß der DE 35 04 606 C2 eine Unterbrechungsstrecke mit Kontaktstiften vorgesehen, wobei die Prüfnadeln je nach Längsposition der Prüfnadel den Kontaktstift betätigen oder nicht.

Es zeigt sich jedoch, dass Fertigungstoleranzen der Stecker, insbesondere der im allgemeinen aus Kunststoff hergestellten Steckergehäuse sowie auch der eingesetzten Kontaktteile bzw. Steckerkontakte aufgrund von z.B. Schrumpfprozessen am Kunststoffteil, unterschiedlichen Fertigungslinien und unterschiedlichen bzw. Änderungen unterworfenen Werkzeugmaschinen eine derartige automatisierte Messung erschweren.

Somit kann bei der Prüfung eine ordnungsgemäße Verrastung angezeigt werden, obwohl diese nicht vorliegt.

Die DE 200 108 214 U1 zeigt einen Verraststift zur Prüfung des mechanischen Sitzes von Elementen in Gehäusen, mit einer Hülse, in der ein Kolben längsverschieblich gegen Federkraft geführt ist. Der Kolben weist eine Kontaktierungsspitze mit zwei Abflachungen auf, wodurch ein im Wesentlichen rechteckiger Querschnitt gebildet ist. Die Federkraft wird durch mindestens zwei in Längsrichtung des Kolbens hintereinander angeordnete Federn ausgeübt.

Die DE 94 11 164 U1 beschreibt eine Vorrichtung zur Prüfung einer ordnungsgemäßen Einrastung eines Kontaktstiftes in einem Steckergehäuse. Die Vorrichtung weist einen Gegenkontakt und einen Schalter auf, die aus zwei getrennten Teilen bestehen.

Die EP 1 209 777 A1 beschreibt einen Prüfstift, der eine in einer Hülse federvorgespannt aufgenommene Messsonde aufweist.

Der Erfindung liegt die Aufgabe zugrunde, einen Prüfstift, eine Prüfvorrichtung sowie ein Verfahren zum Prüfen von Steckern zu schaffen, mit denen eine zuverlässige Prüfung auf Verrastungsfehler bei einer automatisierten Messung gewährleistet wird.

Diese Aufgabe wird durch einen Prüfstift nach Anspruch 1, eine Prüfvorrichtung nach Anspruch 20 und ein Verfahren nach Anspruch 26 gelöst. Die Unteransprüche beschreiben bevorzugte Weiterbildungen.

Erfindungsgemäß wird somit ein aus im Wesentlichen drei Bauteilen zusammengesetzter Prüfstift geschaffen, wobei zusätzlich zu der inneren Prüfnadel und dem äußeren Nadelkörper ein als Zwischenhülse ausgebildeter Auflagekolben vorgesehen ist, der in dem Nadelkörper längsverschiebbar federvorgespannt aufgenommen ist und in dem wiederum die Prüfnadel federvorgespannt aufgenommen ist.

Der Erfindung liegt der Gedanke zugrunde, beim Verfahren der Ebene mit den Prüfstiften relativ zu der Adapterplatte aufgrund der oben beschriebenen Toleranzen und Abweichungen den Nullpunkt der Messung nicht durch die verfahrbare Ebene selbst zu definieren, sondern für jeden Prüfstift den Nullpunkt durch seinen als Zwischenhülse ausgebildeten Auflagekolben festzulegen, der mit einer Auflagefläche am Steckergehäuse zur Anlage kommt. Jeder Auflagekolben sucht sich somit selbst seine Anlage an der Steckerfrontseite des Steckergehäuses, wobei seine Anlagefläche einen ersten Messpunkt bildet, der später als Nullpunkt bzw. Referenzpunkt für die Messung dient. Hierzu ist der Auflagekolben federvorgespannt längsverschiebbar in dem Nadelkörper aufgenommen. Der Nadelkörper wird mit dem vorgegebenen Verstellhub der Ebene von z.B. 5 mm verfahren; er kann z.B. in eine Einpresshülse der verfahrbaren Ebene eingeschraubt sein.

Die Prüfnadel ist wiederum längsverschiebbar federvorgespannt in dem Auflagekolben aufgenommen und gelangt gegen den jeweiligen zu prüfenden Steckerkontakt des Steckers, wodurch ein zweiter Messpunkt ausgebildet wird. Hierdurch wird weiterhin eine Kontaktierung erreicht, die ergänzend für eine elektrische Prüfung dieses Steckerkontaktes in dem betreffenden Kabelbaum herangezogen werden kann.

Erfindungsgemäß kann nunmehr die Differenz der beiden Messpunkte zur Ermittlung der Relativverschiebung der Prüfnadel in dem Auflagekolben dienen. Hierbei können die beiden Messpunkte separat gemessen werden, oder es wird durch einen geeigneten Sensor direkt die Relatiwerschiebung ermittelt.

Somit können Messfehler durch Fertigungstoleranzen, die zu Änderungen der Position des Steckerkontaktes in dem Steckergehäuse führen, verringert oder ganz beseitigt werden und hierdurch eine ordnungsgemäße Prüfung auf die Verrastung des Steckerkontakts durchgeführt werden.

Hierbei ist der Aufwand des Prüfverfahrens gegenüber demjenigen der DE 35 04 606 C2 nicht erhöht, da weiterhin lediglich die verfahrbare Ebene mit den eingesetzten Prüfstiften gegen die Adapterplatte mit dem zu prüfenden Stecker zu führen ist.

Zur Messung kann am hinteren Ende des Prüfstiftes ein Sensor vorgesehen sein, der die Relatiwerschiebung der Prüfnadel gegenüber dem Auflagekolben mit unterschiedlichen Messprinzipien messen kann. Der Sensor kann hierbei z.B. fest am Auflagekolben befestigt sein, z.B. durch eine Schraubverbindung. Weiterhin kann auch eine Unterbrecherstrecke vorgesehen sein, wie sie in der DE 35 04 606 C2 vorgesehen ist.

Gemäß einem weiteren Aspekt der Erfindung kann ergänzend auch die Relatiwerschiebung des Auflagekolbens gegenüber dem äußeren Nadelkörper ermittelt werden, um Aussagen über die Position der Steckerfrontseite des Steckergehäuses zu erhalten. Hierdurch können Aussagen über Fertigungstoleranzen und mögliche Fertigungsprobleme gewonnen werden, die ergänzend zur Verbesserung des Fertigungsverfahrens herangezogen werden können.

Ein weiterer Messpunkt kann die Position des zu prüfenden Steckers in der Adapterplatte erfragen und auswerten.

Erfindungsgemäß ist weiterhin eine statistische Auswertung der Relativverschiebung der Prüfnadel im Auflagekolben, gegebenenfalls auch der Verschiebung des Auflagekolben im Nadelkörper möglich. Entsprechend ist auch eine statistische Auswertung des Messpunktes der Position des zu prüfenden Steckers in der Adapterplatte möglich.

Bei einer derartigen statistischen Auswertung über eine Vielzahl von Messungen können Aussagen über besonders vorteilhafte Bereiche, d.h. Bereiche mit statistisch geringen Fehlern als "grüne Bereiche", Bereiche mit einer hohen Fehlerquote als schlechte Bereiche oder dazwischen liegende "graue Bereiche" gewonnen werden.

Erfindungsgemäß sind somit unter anderem folgende weitere Aspekte relevant:

Der Sensor kann die Längsverschiebung der Prüfnadel gegenüber dem Auflagekolben messen durch ein Piezoelement, induktiv, kapazitiv, optisch, Ultraschall, resistiv oder durch einen oder mehrere Schalter, z.B. Mikroschalter.

Weiterhin kann der Sensor einen Durchmesser aufweisen, der kleiner oder gleich dem Durchmesser des Nadelkörpers ist.

Weiterhin kann der Auflagekolben mit einem Bauteil des Sensors, z.B. dem Sensorgehäuse, fest verbunden ist und der Sensor die Längsverschiebung der Prüfnadel messen.

Die Prüfnadel kann sich durch den Sensor hindurch erstrecken.

Im oberen Bereich des Nadelkörpers kann ein Ansatzmittel, z.B. ein Vierkant oder Sechskant, für ein Werkzeug zum Ausdrehen des Nadelkörpers aus der Einspresshülse ausgebildet sein.

Es können auswechselbar sein:

Der Nadelkörper mitsamt Auflagekolben und Prüfnadel und/oder die Prüfnadel aus dem Auflagekolben und/oder der Auflagekolben aus dem Nadelkörper.

Die Prüfvorrichtung kann insbesondere aufweisen:
Haltemittel, z. B. einen pneumatischen, elektrischen, mechanischen oder hydraulisch betätigten Zylinder zum Fixieren des eingesetzten Steckers in der Adapterplatte.

Einen Schaltstift, der bei Einsetzen des Steckers in die Kontur der Adapterplatte ein Steuersignal zur Betätigung des Haltemittels zur Fixierung des Steckers ausgibt.

Eine Unterbrecherstrecke, die in Abhängigkeit des Prüfergebnisses durch die Prüfnadel unterbrochen wird.

Die Prüfvorrichtung kann zur Überprüfung der Verrastung eines Steckerkontaktes und weiterhin zur Überprüfung einer elektrischen Kontaktierung oder einer Lichtwellenleiterverbindung oder einer pneumatischen Verbindung ausgebildet sein.

Das erfindungsgemäße Verfahren zum Prüfen eines Steckers kann insbesondere folgende Merkmale oder Schritte aufweisen:

Die gemessene Relatiwerschiebung der Prüfnadel gegenüber dem Auflagekolben wird nachfolgend mit einem Referenzwert verglichen.

Es kann eine statistische Auswertung der gemessenen Relatiwerschiebung der Prüfnadeln gegenüber den Auflagekolben über mehrere Messungen erfolgen.

Ergänzend kann auch die Relatiwerschiebung des Auflagekolbens gegenüber dem äußeren Nadelkörper gemessen und mit einem Referenzwert verglichen werden.

Auf die Prüfnadeln kann eine vorgegebene Federkraft, z.B. 15N, ausgeübt werden.

Weiterhin kann ergänzend entweder eine elektrische Kontaktierung oder eine Lichtwellenleiterverbindung oder eine pneumatische Verbindung zwischen dem Steckerkontakt und der Prüfnadel gemessen werden.

Die Erfindung wird im Folgenden anhand der beiliegenden Zeichnungen an einigen Ausführungsformen erläutert. Es zeigen:
Die Figuren 1 bis 3 eine erste Ausführungsform:

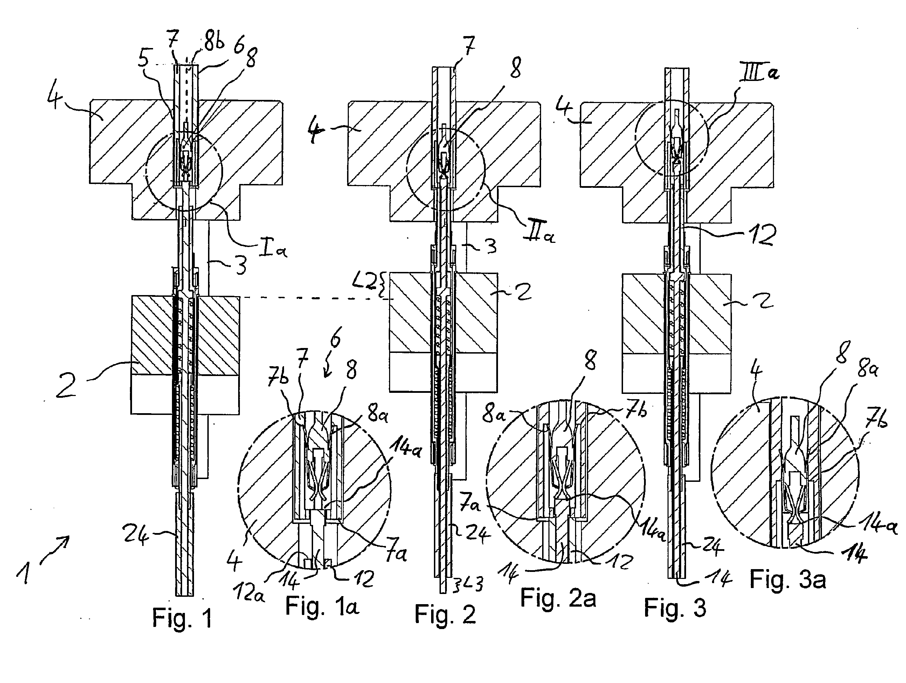

   - Fig. 1: eine erfindungsgemäße Prüfvorrichtung, die an einen Ste- cker mit zu prüfendem Steckerkontakt angesetzt ist, im Grundzustand vor der Prüfung, im Axialschnitt,
   - Fig. 1 a: die Einzelheit la aus Fig. 1,
   - Fig. 2: die Anordnung aus Fig. 1 bei Prüfung eines verrasteten Steckkontaktes,
   - Fig. 2a: die Einzelheit IIa aus Fig. 2,
   - Fig. 3: die Anordnung aus Fig. 1 bei Prüfung eines nicht verrasteten Steckkontaktes,
   - Fig. 3: die Einzelheit IIIa aus Fig. 3,

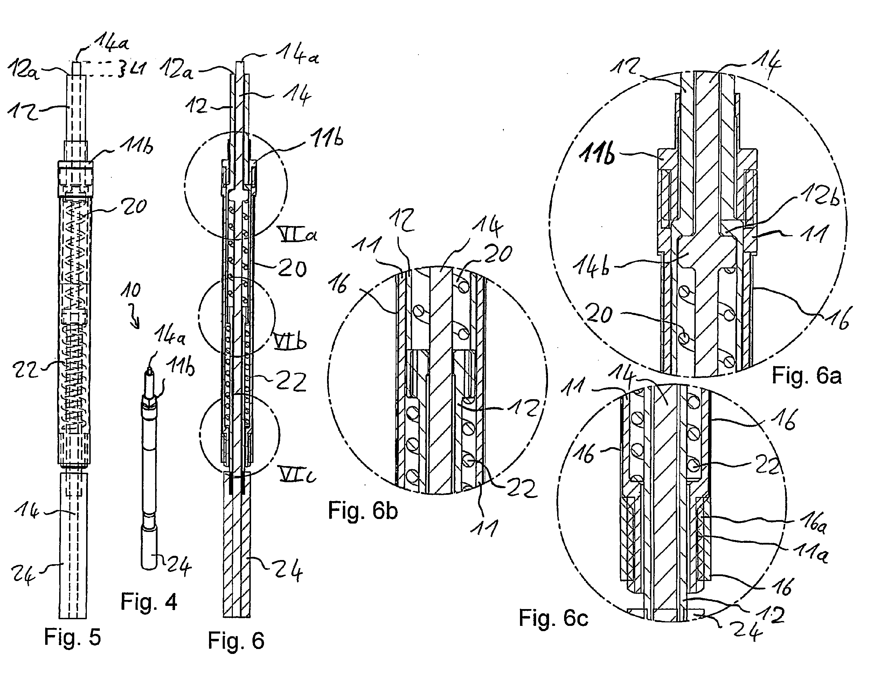

Die Figuren 4 bis 6 eine zweite Ausführungsform:
   - Fig. 4: eine perspektivische Ansicht des Prüfstiftes,
   - Fig. 5: eine Seitenansicht bzw. Durchsicht des Prüfstiftes,
   - Fig. 6: einen Längsschnitt bzw. Axialschnitt des Prüfstiftes,
   - Fig. 6a: die Einzelheit VIa aus Fig. 6 mit dem Vierkantbereich,
   - Fig. 6b: die Einzelheit VIb aus Fig. 6 mit der Abstützung der Vor- spannfedern,
   - Fig. 6c: die Einzelheit VIc aus Fig. 6 mit den Gewindebefestigungen zwischen Einspresshülse und Nadelkörper sowie teilweise auch zwischen Auflagekolben und Sensorgehäuse;

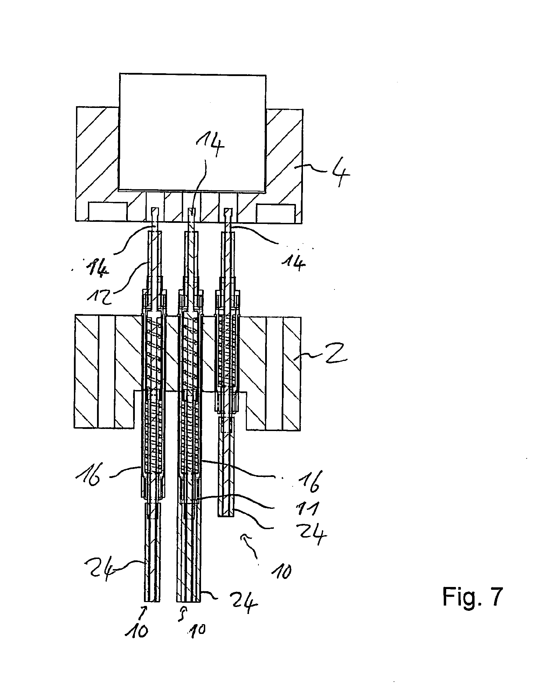

   - Fig. 7: eine Darstellung von drei verschiedenen Ausführungsformen von Prüfstiften.

Eine Prüfvorrichtung 1 ist in Fig. 1 bis 3 nur teilweise dargestellt und entspricht im Aufbau im Wesentlichen derjenigen der DE 35 04 606 C2. Die Prüfvorrichtung 1 weist somit eine in Längsrichtung (d.h. in den Figuren nach oben) verfahrbare Ebene 2 auf, die durch z.B. einen nicht gezeigten pneumatischen Hubzylinder an einer Stange 3 relativ zu einer Adapterplatte 4 verfahren wird. Die Adapterplatte 4 weist auf ihrer Oberseite eine z.B. gefräste Kontur 5 auf, die zur Aufnahme eines zu prüfenden Steckers 6 dient und entsprechend komplementär zu dem Stecker 6 ausgebildet ist.

Der Stecker 6 weist - wie z.B. aus Fig. 1 ersichtlich ist - ein Steckergehäuse 7 mit einer Steckerfrontseite 7a und mindestens einen in das Steckergehäuse 7 gesetzten Steckerkontakt 8 auf. Der Steckerkontakt 8 weist gemäß der Ausführungsform der Fig. 1 bis 3 ein oder mehrere Haltefedern 8a auf, die derartig gespreizt sind, dass sie an einer Haltekante 7b des Steckergehäuses 7 verrastend anliegen. Der Steckerkontakt 8 wird am vorderen Ende der jeweiligen, in Fig. 1 gestrichelt gezeigten Leitung 8b von hinten, d.h. in den Fig. 1 bis 3 von oben her, in das Steckergehäuse 7 geführt und verrastet bei richtiger Positionierung mit seinen Haltefedern 8a an der Haltekante 7b des Steckergehäuses 7. In Fig. 1a liegt eine ordnungsgemäße Verrastung vor. Hierbei liegt der Steckerkontakt 8a an der vorderen Öffnung des Steckergehäuses 7a zur Aufnahme entsprechender Kontakte eines komplementär geformten Steckers nach vorne frei.

Zur Prüfung der Verrastung der ein oder mehreren Steckerkontakte 8 in dem Steckergehäuse 7 sind in der Prüfvorrichtung 1 Prüfstifte 10 vorgesehen, wobei jedem Steckerkontakt 8 jeweils ein Prüfstift 10 zugeordnet ist. Der Prüfstift 10 weist erfindungsgemäß einen äußeren Nadelkörper 11, einen in dem Nadelkörper 11 längsverschiebbar geführten Auflagekolben 12 und eine in dem Auflagekolben 12 längsverschiebbar geführte Prüfnadel 14 auf. Es ergibt sich somit ein - vom Grundprinzip her - dreiteiliger Aufbau aus zwei konzentrischen Hülsen, nämlich dem Nadelkörper 11 und dem Auflagekolben 12, und einer inneren Prüfnadel 14, die mit ihrer vorderen Anlagefläche/ Prüfnadelspitze 14a den Steckerkontakt 8 kontaktiert.

In eine entsprechende Bohrung der verfahrbaren Ebene 2 ist eine Hülse 16, z.B. als Einpresshülse 16, fest eingesetzt, die detaillierter in den Fig. 4 bis 6, 6a, b, c dargestellt ist. Die Einspresshülse 16 ist von oben her in die Platte 2 eingepresst und weist an ihrem unteren Ende ein Innengewinde 16a auf. Der Prüfstift 10 ist mit seinem äußeren Nadelkörper 11 passend bzw. ohne Spiel in die Einspresshülse 16 gesetzt und mit einem an seinem unteren Ende ausgebildeten Außengewinde 11a in das Innengewinde 16a der Einspresshülse 16 geschraubt, so dass der Nadelkörper 11 während des Betriebs über die Einspresshülse 16 fest in der verfahrbaren Platte 2 aufgenommen ist. Grundsätzlich kann die Gewindeverbindung statt in einem unteren Bereich der Einspresshülse 16 und des Nadelkörpers 11 auch in einem oberen Bereich vorgesehen sein. Statt der Gewindeverbindung 16a und 11a kann auch eine Bajonett-Verbindung vorgesehen sein. Das obere Ende des Nadelkörpers 11 ragt aus der Einspresshülse 16 heraus und ist derartig ausgebildet, dass der Nadelkörper 11 durch ein Werkzeug gedreht werden kann. Gemäß Fig. 4 kann hierzu z.B. ein Vierkant 11 b einteilig mit dem Nadelkörper 11 oder als weiteres Bauteil starr auf diesen aufgesetzt sein, so dass durch Drehen des Vierkants 11 b der Nadelkörper 11 aus der Einspresshülse 16 herausgedreht und somit der gesamte Prüfstift 10 nach oben aus der verfahrbaren Platte 2 herausgezogen werden kann.

Zwischen der Prüfnadel 14 und dem Auflagekolben 12 ist eine erste Feder 20 vorgesehen, die gemäß der gezeigten Ausführungsform eine um die Prüfnadel 14 gelegte erste Schraubenfeder 20 ist. Zwischen dem Auflagekolben 12 und dem äußeren Nadelkörper 11 ist eine zweite Feder, gemäß der gezeigten Ausführungsform eine um den Auflagekolben 12 gelegte zweite Schraubenfeder 22 vorgesehen. Hierbei ist die erste Feder 20 oberhalb bzw. in Längsrichtung vor der zweiten Feder 22 angeordnet.

In den Fig. 4 bis 6 sowie in Fig. 1, 1a ist der Grundzustand des Prüfstiftes 10 gezeigt. In diesem Grundzustand ragt die Prüfnadel 14 vorne mit einer Grund-Länge L0 aus dem Auflagekolben 12 heraus, d.h. zwischen der Anlagefläche 14a der Prüfnadel 14 und der Auflagefläche 12a des Auflagekolbens 12 ist im nicht eingedrückten Grundzustand die Längendifferenz L0 ausgebildet. Hierbei stößt eine z.B. in Fig. 6a gezeigte Schulter 14b der Prüfnadel 14 unter der Vorspannwirkung der ersten Feder 20 gegen eine Querschnittsverengung 12b des Auflagekolbens 12. Unterhalb dieser Querschnittsverengung 12b verläuft der Auflagekolben 12 mit größerem Radius und nimmt hierdurch die erste Feder 20 zwischen sich und der inneren Prüfnadel 14 auf. In einem mittleren Bereich des Prüfstiftes 10 verengt sich der Querschnitt des Auflagekolbens 12 wieder, wie z.B. aus Fig. 6b ersichtlich ist, und verläuft weiter nach unten mit kleinerem Querschnitt dichter um die Prüfnadel 14 gelegt, so dass die zweite Feder 22 zwischen den Auflagekolben 12 und den äußeren Nadelkörper 11 gesetzt ist. Die erste Feder 20 stützt sich somit an ihrem unteren Ende am Auflagekolben 12 und an ihrem oberen Ende an der Schulter 14b der Prüfnadel 14 ab. Die zweite Feder 22 stützt sich an ihrem unteren Ende am Nadelkörper 11 und an ihrem oberen Ende am Auflagekolben 12 ab. Im gezeigten Grundzustand sind beide Federn etwas vorgespannt.

L0 ist hierbei vorteilhafterweise länger als der Messweg L1, mit dem die Prüfnadel 14 in der jeweiligen Prüfung vorne aus dem Auflagekolben 12 heraus ragt; somit kann mit dieser analogen Wegmessung auch der Verfahrweg im Schlechtbereich bewertet werden. L1 ist somit der Messweg des zu prüfenden Kontaktes in seiner optimalen Sitzposition (mit der Berücksichtigung aller Fertigungs- und sonstiger Tolleranzen) und mit der sicheren Lageerkennung des Kontaktteiles in einer fehlerhaften Position, wo keine sichere physikalische Fixierung mehr auf das Kontaktteil einwirkt und sichert. Die physikalische Größe ist vom Kontakttyp und vom Steckertyp abhängig. L1 ist die theoretische Position für eine Gut/Schlecht Bewertung.

Am unteren Ende des Prüfstiftes 10 ist ein Sensor 24 angeordnet, der die Relatiwerschiebung zwischen dem Auflagekolben 12 und der Prüfnadel 14 misst. Der Sensor ist somit als Wegmess-System ausgebildet, das z.B. mit einem Piezoelement oder induktiv, kapazitiv, optisch, auf Ultraschallbasis oder auch durch eine Reihe von in definierten Abständen vorgesehenen Schaltern, insbesondere Mikroschaltern, ausgebildet sein kann. Als Sensor kann auch ein weiterer. Kontakt unterhalb des Prüfstiftes 10 dienen, der in den verschiedenen Prüfzuständen unterschiedlich geschaltet wird; hierzu kann eine Unterbrechungsstrecke vorgesehen sein. Der Sensor 24 ist hierbei derartig schmal ausgebildet, dass er nach Lösen des Vierkants 11 b mit dem Prüfstift 10 bzw. als Teil des Prüfstifts 10 nach oben aus der Einspresshülse 16 herausgezogen werden kann. Gemäß der gezeigten Ausführungsform ist der Sensor 24 fest mit dem Auflagekolben 12 verbunden, z.B. über eine Gewindeverbindung, so dass der Sensor 24 direkt die Relativverschiebung der Prüfnadel 14 gegenüber dem Auflagekolben 12 messen kann.

Gemäß Fig. 1 wird ein zu prüfender Stecker 6 vom Bediener in die Kontur 5 an der Oberseite der Adapterplatte 4 gesteckt, wobei ein in den Figuren nicht gezeigter pneumatisch, mechanisch, hydraulischer oder elektrisch betätigter Haltezylinder den zu prüfenden Stecker 6 fixiert. Der pneumatische Haltezylinder kann z.B. gemäß der Darstellung der DE 35 04 606 C2 ausgebildet sein, wo ein oder mehrere pneumatische Zylinder den zu prüfenden Stecker seitlich fixieren. Zur Auslösung des pneumatischen Zylinders kann wiederum ein hier in den Figuren nicht gezeigter Schaltstift vorgesehen sein, der beim Einsetzen des Steckers 6 geschaltet wird und hierdurch den pneumatischen Zylinder auslöst.

Nachfolgend wird die verstellbare Ebene 2 (bzw. verstellbare Platte) gegenüber der Adapterplatte 4 nach oben verfahren, z.B. um eine vordefinierte Wegstrecke von L2 = 5 mm. Falls ein Stecker 6 mit mehreren Steckerkontakten 8 zu prüfen ist, sind entsprechend in der verfahrbaren Platte 2 mehrere Prüfstifte 10 aufgenommen, die gleichzeitig um die vordefinierte Wegstrecke von L2 = 5mm nach oben verschoben werden.

Erfindungsgemäß bilden nicht die äußeren Nadelkörper 11, sondern jeweils der in dem Nadelkörper 11 aufgenommene Auflagekolben 12 den Nullpunkt für die nachfolgende Messung. Die Auflagekolben 12 gelangen bei der Verschiebung um L2 mit ihrer Auflagefläche 12a jeweils gegen die Steckerfrontseite 7a und die Prüfnadel 14 gelangt mit ihrer Prüfnadelspitze 14a gegen den jeweiligen Steckerkontakt 8 und drückt gegen diesen mit einer vorgegebenen Kraft von z. B. 15 N. Diese Kraft wird derartig gewählt, dass sie ausreichend ist zum Ausdrücken eines nicht sicher fixierten Steckerkontaktes. Somit kann jeder Auflagekolben 12 federvorgespannt längsverschiebbar gegen die jeweilige Auflagefläche an der Steckerfrontseite 7a gelangen, auch wenn der betreffende Stecker 6 entsprechende Toleranzen aufweist, z.B. Toleranzen in seinem Steckergehäuse 7, Toleranzen in der Ausbildung oder Positionierung eines Steckerkontaktes 8, oder falls Toleranzen in der Ausfräsung der Kontur 5, in der Adapterplatte 4 und/oder in der Prüfmoduleinstellung vorliegen. Eine ungleichmäßige Höhe der Steckerfrontseite 7a ist für die nachfolgende Messung nicht relevant, da sich jeder Auflagekolben 12 jeweils eine Gegenfläche an der Steckerfrontseite 7a sucht.

Die Fig. 2 und 3 zeigen Prüfsituationen nach der Verschiebung der Adapterplatte 2 um L2 = 5mm. Gemäß Fig. 2 liegt eine ordnungsgemäße Verrastung des Steckerkontaktes 8 mit seinen Haltefedern 8a an der Haltekante 7b des Steckergehäuses 7 vor. Dementsprechend wird die Prüfnadel 14 gegenüber dem Auflagekolben 12 um eine Wegstrecke L3 nach hinten verschoben, die entsprechend in dem Sensor 24 oder einem darunter angeordneten Schalter sensiert wird.

Fig. 3 zeigt eine nicht ordnungsgemäße Verrastung, bei der der Steckerkontakt 8 mit seinen Haltefedern 8a nicht an der Haltekante 7b des Steckergehäuses 7 anliegt. Bei Einwirken der vorgegebenen Kraft von 15 Newton drückt die Prüfnadel 14 den Steckerkontakt 8 nach innen ein, so dass die relative Verschiebung der Prüfnadel 14 gegenüber dem Auflagekolben 12 kleiner als L3 ist. Der Sensor 24 misst somit eine geringere oder gar keine Relatiwerschiebung der Prüfnadel 14 gegenüber dem Auflagekolben 12. In Fig. 3 ist L3 = 0, da die Prüfnadel 14 den Steckerkontakt 8 vorständig eindrücken kann.

Erfindungsgemäß können unterschiedliche Baugruppen gestaltet werden und wahlweise mit den oben beschriebenen Ausführungsformen kombiniert werden: zum einen kann wie oben beschrieben eine Funktionsgruppe aus dem Prüfstift 10 mit gefederter Prüfnadel 14, gefedertern Auflagekolben 12 und Sensor 24 gebildet sein, die in die die weitere Funktionsgruppe bildenenden Hülse 16 eingeschraubt ist.

Weitere Möglichkeiten zur Ausgestaltung der einzelnen Baugruppen sind:
1)
   Auswechselbare Baugruppe: gefederte Prüfnadel 14
   Fest Installierte Baugruppen:
   Der Auflagekolben 12 bildet mit der Hülse 16 eine Baugruppe, der Sensor 24 ist mit der Hülse 16 fest verbunden oder als Teil der Hülse 16 ausgebildet.
2)
   Auswechselbare Baugruppe: gefederte Prüfnadel 14 und Auflagekolben 12
   Fest Installierte Baugruppen:
   Der Sensor 24 ist ein Bestandteil der Hülse 16 und bindet in seiner Messung eine weitere Position, d.h. die Position der Hülse 16, mit ein.
3)
   Auswechselbare Baugruppe: die gefederte Prüfnadel 14
   Auswechselbare Baugruppe: der gefederter Auflagekolben 12,
   (eventuell auch ein auswechselbarer Sensor 24).
   Fest Installierte Baugruppen:
   Der Sensor 24 ist ein Bestandteil der Hülse 16 und bindet wie unter 2) eine weitere Positionsmessung, d.h. die Position der Hülse 16, mit ein.

Fig. 7 zeigt drei Ausführungsformen von Prüfstiften 10, 110, 210, die in einer gemeinsamen verfahrbaren Ebene 2 angebracht sind, wobei ihre Merkmale durch gleiche oder ähnliche Bezugszeichen beschrieben werden. Die Funktionen sind im wesentlichen unverändert bis auf die folgenden Merkmale:

Die linke Ausführungsform des Prüfstiftes 10 entspricht der oben in den Fig. 1 bis 6 beschriebenen Ausführungsform.

Bei der mittleren Ausführung als Prüfstift 10 ist der Sensor 24 an der Einpresshülse 16 (oder alternativ hierzu grundsätzlich auch am Nadelkörper 11) befestigt. Es ist kein Lösen des Prüfstiftes mitsamt Einpresshülse nach oben möglich. Hierbei misst der erste Messpunkt die Abweichung der Prüfnadel 14 zu der Adapterplatte 4 und der zweite Messpunkt die Abweichung der Prüfnadel 14 zum Auflagekolben 12 oder zur Adapterplatte 4.

Die rechte Ausführung entspricht grundsätzlich der linken, ersten Ausführungsform, wobei allerdings die Funktion der zwischen der Prüfnadel 14 bzw. 14 und dem Auflagekolben 12 vorgesehenen ersten Feder 20 durch den Sensor 24 realisiert wird, d.h. der Sensor 24 weist eine Federeinrichtung zur Vorspannung der Prüfnadel 14 gegenüber dem Auflagekolben 12 auf.

Bei allen Ausführungsformen kann die Prüfnadel 14 zum Testen von Rundkontakten ohne Verdrehsicherung, oder aber zum Testen von konturierten Kontaktteilen/Steckerkontakten 8 mit einer dem Kontaktteil angepassten bildlichen Ausbildung ihrer Prüfnadelspitze 14a und einer Verdrehsicherung ausgebildet sein, damit sie sich nicht unkontrolliert um ihre innere Längsachse dreht. Hierbei ist vorteilhafterweise auch eine Verdrehsicherung des Auflagekolbens 12 in dem Nadelkörper 11 vorgesehen.

Weiterhin kann bei allen Ausführungsformen auch eine Konturierung der Auflagefläche 12a des Auflagekolbens 12 vorgesehen sein, die einer entsprechenden Konturierung der Steckerfrontseite 7a angepasst ist. Hierbei ist vorteilhafterweise eine Verdrehsicherung des Auflagekolbens 12 in dem Nadelkörper 11 vorgesehen.

Bei allen Ausführungsformen kann die Prüfnadel 14 mit ihrer Kontaktierung mit dem zu prüfenden Steckerkontakt 8 auch eine Stromverbindung zum Messen von Prüfstrom herstellen. Somit kann zusätzlich zu der Prüfung auf ordnungsgemäße Verrastung auch eine elektrische Kontaktierungsprüfung, insbesondere auch in einem komplexeren Kabelbaum, durchgeführt werden.

Weiterhin kann die Prüfnadel 14 für die Übermittlung von LWL (Lichtwellenleitertechnik) und pneumatischen Medien ausgebildet sein.

## Patentansprüche

1. Prüfstift für eine Prüfvorrichtung (1) zum Prüfen von Steckern (6), wobei der Prüfstift (10) aufweist:
einen Nadelkörper (11) zum Einsatz in ein verfahrbares Element (2) der Prüfvorrichtung (1), und
eine innerhalb des Nadelkörpers (11) federvorgespannt aufgenommene Prüfnadel (14) zur Anlage an einem Steckerkontakt (8) des zu prüfenden Steckers (6),
**dadurch gekennzeichnet, dass**
in dem Nadelkörper (11) ein hülsenförmiger Auflagekolben (12) federvorgespannt längsverschiebbar aufgenommen ist, der eine Anlagefläche (12a) zur Anlage an der Steckerfrontseite (7a) des Steckergehäuses (7) des zu prüfenden Steckers (6) aufweist, und
die Prüfnadel (14) in dem Auflagekolben (12) federvorgespannt längsverschiebbar aufgenommen ist.

2. Prüfstift nach Anspruch 1, **dadurch gekennzeichnet, dass** er in seinem unteren Bereich einen Sensoranschluss für einen Sensor (24) zur Sensierung der Längsverschiebung der Prüfnadel (14) relativ zu dem Auflagekolben (12) aufweist.

3. Prüfstift nach Anspruch 2. **dadurch gekennzeichnet, dass** er nicht mit dem Sensor (24) verbunden ist, wobei die Positionen der Prüfnadel und/oder des Auflagekolbens (12) durch den an einer in dem verschiebbaren Element (2) aufgenommenen Hülse (16) angebrachten Sensor (24) messbar sind.

4. Prüfstift nach einem der vorherigen Ansprüche, **dadurch gekennzeichnet, dass** die Prüfnadel (14) und der Auflagekolben (12) separat auswechselbar sind.

5. Prüfstift nach einem der vorherigen Ansprüche, **dadurch gekennzeichnet, dass** der Nadelkörper (11) in seinem unteren oder oberen Bereich ein Außengewinde (11 a) oder Bajonettsystem aufweist zum Einschrauben oder Eindrehen des Nadelkörpers (11) in ein Innengewinde (16a) oder eine Innenaufnahme einer in dem verschiebbaren Element (2) aufgenommenen Hülse (16).

6. Prüfstift nach einem der vorherigen Ansprüche, **dadurch gekennzeichnet, dass** er zwei in Längsrichtung hintereinander angeordnete Schraubenfedern (20, 22) aufweist, wobei die erste Schraubenfeder (20) zur Vorspannung der Prüfnadel (14) gegenüber dem Auflagekolben (12) und die zweite Schraubenfeder (22) zur Vorspannung des Auflagekolbens (12) gegenüber dem Nadelkörper (11) vorgesehen ist.

7. Prüfstift nach Anspruch 6, **dadurch gekennzeichnet, dass** die erste Schraubenfeder (20) um die Prüfnadel (14) gelegt ist und sich an ihrem vorderen Ende an einer Schulter (14b) der Prüfnadel (14) und an ihrem hinteren Ende am Auflagekolben (12) abstützt, und
die zweite Schraubenfeder (22) sich an ihrem vorderen Ende am Auflagekolben (12) und an ihrem hinteren Ende am Nadelkörper (11) abstützt.

8. Prüfstift nach einem der Ansprüche 2 bis 5, **dadurch gekennzeichnet, dass** der Sensor (24) eine Federeinrichtung zur Vorspannung der Prüfnadel aufweist und weiterhin eine zweite Feder, z. B. Schraubenfeder (22), zur Vorspannung des Auflagekolbens (12) gegenüber dem Nadelkörper (11) vorgesehen ist.

9. Prüfstift nach einem der vorherigen Ansprüche, **dadurch gekennzeichnet, dass** im Grundzustand der Auflagekolben (12) aufgrund seiseiner Federvorspannung aus dem Nadelkörper (11) hervorragt und die Prüfnadel (14) aufgrund ihrer Federvorspannung aus dem Auflagekolben (12) hervorragt.

10. Prüfstift nach einem der vorherigen Ansprüche, **dadurch gekennzeichnet, dass** die Prüfnadel (14) entweder in dem Auflagekolben (12) verdrehbar gelagert ist oder eine konturierte Prüfnadelspitze (14a) aufweist und in dem Auflagekolben (12) verdrehsicher geführt ist.

11. Prüfstift nach einem der vorherigen Ansprüche, **dadurch gekennzeichnet, dass** durch die Prüfnadel (14) bei Anlage an dem zu prüfenden Steckerkontakt (8) eine elektrische Kontaktierung oder eine Verbindung für eine Lichtwellenleitung oder eine Verbindung für ein pneumatisches Medium ausbildbar ist.

12. Prüfvorrichtung (1) unter Verwendung eines Prüfstiftes (10) nach einem der vorherigen Ansprüche, wobei die Prüfvorrichtung (1) aufweist:
eine Adapterplatte (4) mit einer auf ihrer Oberseite ausgebildeten Kontur (5) zur Aufnahme des zu prüfenden Steckers (6), und
eine verfahrbare Ebene (2) mit dem mindestens einen Prüfstift (10),
wobei zur Prüfung die verfahrbare Ebene (2) zu der Adapterplatte (4) hin verstell bar ist und die Prüfnadel (14) gegen einen Steckerkontakt (8) des zu prüfenden Steckers (6) drückt.

13. Prüfvorrichtung nach Anspruch 12, **dadurch gekennzeichnet, dass** der Sensor (24) fest mit der Adapterplatte (4), z. B. fest mit einer in der Adapterplatte (4) eingepressten Einpresshülse (16), ausgebildet ist.

14. Verfahren zum Prüfen eines Steckers (6) mit mindestens einem Steckerkontakt (8) auf ordnungsgemäße Verrastung, mit mindestens folgenden Schritten:
Einsetzen des zu prüfenden Steckers (6) in eine Kontur (5) auf der Oberseite einer Adapterplatte (4) einer Prüfvorrichtung (1),
Fixierung des Steckers (6) in der Adapterplatte (4),
Verfahren einer Ebene (2) mit Prüfstiften (10) zu der Adapterplatte (4),
wobei die Anzahl der in der verfahrbaren Ebene (2) aufgenommenen Prüfstifte (10) der Anzahl an zu prüfenden Steckerkontakten (8) entspricht,
Anlage der Prüfnadelspitzen (14a) der Prüfstifte (10) an den Steckerkontakten (8) unter Ausbildung jeweils eines ersten Messpunktes,
Abstützung vorderer Anlageflächen (12a) der Auflagekolben (12) der Prüfstifte (10) an dem Steckergehäuse (7) des Steckers (6), und
Messung oder Ermittlung der Relatiwerschiebung der Prüfnadeln (14) gegenüber den Auflagekolben (12).

15. Verfahren nach Anspruch 14, **dadurch gekennzeichnet, dass** die Relativverschiebung der Prüfnadeln (14) gegenüber den Auflagekolben (12) direkt gemessen wird, und
durch die Anlage des Auflagekolbens (12) an der Steckerfrontseite des Steckers ein erster Messpunkt und durch die Anlage der Prüfnadel an den Steckerkontakt des Steckers ein zweiter Messpunkt gebildet wird und die Relativverschiebung der Prüfnadeln (14) gegenüber den Auflagekolben (12) als Differenz der beiden Messpunkte ermittelt wird.

## Claims

1. Test probe for a test apparatus (1) for testing plug-type connectors (6), wherein the test probe (10) has a needle body (11) for insertion into a movable element (2) of the test apparatus (1), and
a test needle (14) which is held by spring prestress inside the needle body (11) for making contact with a plug-type connector contact (8) of the plug-type connector (6) to be tested,
**characterised in that**
a sleeve-like support piston (12) which has a contact surface (12a) for making contact with the plug-type connector front face (7a) of the plug-type connector housing (7) of the plug-type connector (6) to be tested, is held by spring prestress in a longitudinally displaceable manner in the needle body (11), and
the test needle (14) is held by spring prestress in a longitudinally displaceable manner in the support piston (12).

2. Test probe according to Claim 1, **characterised in that** it has a sensor connection (24) in its lower area for sensing the longitudinal displacement of the test needle (14) in relation to the support piston (12).

3. Test probe according to Claim 2, **characterised in that** it is not connected to the sensor (24), wherein the positions of the test needle and/or of the support piston (12) can be measured by the sensor (24) which is attached to a sleeve (16) accommodated in the moveable element (2).

4. Test probe according to one of the preceding claims, **characterised in that** the test needle (14) and the support piston (12) are separately interchangeable.

5. Test probe according to one of the preceding claims, **characterised in that** the needle body (11) has an external thread (11a) or bayonet system in its lower or upper area for screwing the needle body (11) into an internal thread (16a) or an internal mount of a sleeve (16) accommodated in the movable element (2).

6. Test probe according to one of the preceding claims, **characterised in that** it has two coil springs (20, 22) arranged lengthwise one behind the other, wherein the first coil spring (20) is provided for prestressing the test needle (14) relative to the support piston (12) and the second coil spring (22) is provided for prestressing the support piston (12) relative to the needle body (11).

7. Test probe according to Claim 6, **characterised in that** the first coil spring (20) is placed around the test needle (14) and is supported at its front end on a shoulder (14b) of the test needle (14) and at its rear end on a support piston (12), and **in that** the second coil spring (22) is supported at its front end on the support piston (12) and at its rear end on the needle body (11).

8. Test probe according to one of claims 2 to 5, **characterised in that** the sensor (24) has a spring device for prestressing the test needle and, furthermore, **in that** a second spring, e.g. a coil spring (22), is provided for prestressing the support piston (12) against the needle body (11).

9. Test probe according to one of the preceding claims, **characterised in that**, in the basic state, the support piston (12) protrudes from the needle body (11) because of its spring prestressing and the test needle (14) protrudes from the support piston (12) because of its spring prestressing.

10. Test probe according to one of the preceding claims, **characterised in that** the test needle (14) either is held in a rotatable manner in the support piston (12), or has a contoured test needle point (14a) and is held in the support piston (12) in a rotation-locked manner.

11. Test probe according to one of the preceding claims, **characterised in that** an electrical contact or a connection for an optical fibre cable or a connection for a pneumatic medium can be formed by the test needle (14) when it makes contact with the plug-type connector contact (8) to be tested.

12. Test apparatus (1) using a test probe (10) according to one of the preceding claims, wherein the test apparatus (1) has
an adapter plate (4) with a contour (5) formed on its upper surface for accommodating the plug-type connector (6) to be tested, and
a movable plane (2) with the at least one test probe (10), wherein - for the purpose of testing - said moveable plane (2) can be displaced towards the adapter plate (4) and the test needle (14) pushes against a plug-type connector contact (8) of the plug-type connector (6) to be tested.

13. Test apparatus according to Claim 12, **characterised in that** the sensor (24) is rigidly formed with the adapter plate (4), e.g. rigidly formed with a press-in sleeve (16) pressed into the adapter plate (4).

14. Method for testing a plug-type connector (6) with at least one plug-type connector contact (8) for correct latching, comprising at least the following steps:
insertion of the plug-type connector (6) to be tested into a contour (5) on the upper surface of an adapter plate (4) of a test apparatus (1),
fixing of the plug-type connectors (6) in the adapter plate (4),
movement of a plane (2) with test probes (10) towards the adapter plate (4), wherein the number of test probes (10) accommodated in the moveable plane (2) corresponds to the number of plug-type connector contacts (8) to be tested,
bringing of the test needle points (14a) of the test probes (10) into contact with the plug-type connector contacts (8), in each case forming a first measuring point,
supporting of the front contact areas (12a) of the support pistons (12) of the test probes (10) on the plug-type connector housing (7) of the plug-type connector (6), and
measurement or detection of the relative displacement of the test needles (14) with regard to the support piston (12).

15. Method according to Claim 14, **characterised in that** the relative displacement of the test needles (14) towards the support pistons (12) is directly measured, and a first measuring point is formed by the support pistons (12) making contact with the front surface of the plug-type connector and a second measuring point is formed by the test needle making contact with the plug-type connector contact of the plug-type connector, and the relative displacement of the test needles (14) in relation to the support pistons (12) is calculated as the difference in the two measuring points.

## Revendications

1. Sonde de test pour un dispositif (1) destiné à tester des fiches (6), la sonde de test (10) présentant :
un corps d'aiguille destiné à être inséré dans un élément déplaçable (2) du dispositif de test (1), et
une aiguille de test (14), qui est reçue, de manière précontrainte par un ressort à l'intérieur du corps d'aiguille (11) et destinée à être posée contre une broche (8) de la fiche à tester (6),
**caractérisée en ce qu'**un piston de support en forme de douille (12) est reçu de manière précontrainte par ressort et déplaçable longitudinalement dans le corps d'aiguille (11) et présente une surface d'appui (12a) destinée à être posée contre le côté face (7a) du boîtier (7) de la fiche (6) à tester et **en ce que** l'aiguille de test (14) est reçue de manière précontrainte par ressort et
déplaçable longitudinalement dans le piston de support (12).

2. Sonde de test suivant la revendication 1, **caractérisée en ce qu'**elle présente, au niveau de sa zone inférieure, un raccordement pour un capteur (24) destiné à capter le déplacement longitudinal de l'aiguille de test (14) par rapport au piston de support (12).

3. Sonde de test suivant la revendication 2, **caractérisée en ce qu'**elle n'est pas reliée au capteur (24), les positions de l'aiguille de test et/ou du piston de support (12) étant mesurables grâce au capteur (24) monté sur une douille (16) reçue dans l'élément déplaçable (2).

4. Sonde de test suivant une des revendications précédentes, **caractérisée en ce que** l'aiguille de test (14) et le piston de support (12) sont échangeables séparément.

5. Sonde de test suivant une des revendications précédentes, **caractérisée en ce que** le corps d'aiguille (11) présente, au niveau de ses zones supérieure et inférieure, un filetage extérieur (11 a) ou un système à baïonnette pour visser ou enclencher le corps d'aiguille (11) dans un filetage intérieur (16a) ou dans une réception intérieure d'une douille (16) reçue dans l'élément déplaçable (2).

6. Sonde de test suivant une des revendications précédentes, **caractérisée en ce qu'**elle présente deux ressorts à boudin (20, 22) disposés l'un derrière l'autre dans le sens longitudinal, le premier ressort à boudin (20) étant prévu pour la précontrainte de l'aiguille de test (14) par rapport au piston de support (12) et le second ressort à boudin (22) pour la précontrainte du piston de support (12) par rapport au corps d'aiguille (11).

7. Sonde de test suivant la revendication 6, **caractérisée en ce que** le premier ressort à boudin (20) est posé autour de l'aiguille de test (14) et s'appuie, à son extrémité avant, sur un épaulement (14b) de l'aiguille de test (14) et, à son extrémité arrière, sur le piston de support (12) et que le second ressort à boudin (22) s'appuie, au niveau de son extrémité avant, sur le piston de support (12) et, au niveau de son extrémité arrière, sur le corps d'aiguille (11).

8. Sonde de test suivant une des revendications 2 à 5, **caractérisée en ce que** le capteur (24) présente un dispositif à ressort pour la précontrainte de l'aiguille de test et, en plus, un second ressort, p. ex. un ressort à boudin (22) pour la précontrainte du piston de support (12) par rapport au corps d'aiguille (11).

9. Sonde de test suivant une des revendications précédentes, **caractérisée en ce qu'**à l'état de base, le piston de support (12) fait saillie du corps d'aiguille (11) en raison de sa précontrainte par ressort et l'aiguille de test (14) fait saillie du piston de support (12) en raison de sa précontrainte par ressort.

10. Sonde de test suivant une des revendications précédentes, **caractérisée en ce que** l'aiguille de test (14) soit est logée de manière rotative dans le piston de support (12), soit présente une pointe d'aiguille de test (14a) contournée et est guidée dans le piston de support (12) de manière à résister à la torsion.

11. Sonde de test suivant une des revendications précédentes, **caractérisée en ce que** l'aiguille de test (14) permet de réaliser une liaison électrique ou une liaison pour un guide d'ondes lumineuses ou une liaison pour un milieu pneumatique lorsqu'elle est posée contre la broche de la fiche (8) à tester.

12. Dispositif de test (1) employant une sonde de test (10) suivant une des revendications précédentes, le dispositif de test (1) présentant une plaque adaptatrice (4) avec un contour (5) réalisé sur sa face supérieure, contour qui est destiné à la réception de la fiche (6) à tester, et un plan déplaçable (2) avec l'au moins une sonde de test (10), le plan déplaçable (2) pouvant, pour l'exécution du test, être réglé en direction de la plaque adaptatrice (4) et l'aiguille de test (14) exerçant une pression sur une broche (8) de la fiche (6) à tester.

13. Dispositif de test suivant la revendication 12, **caractérisé en ce que** le capteur (24) est conçu de manière à former une seule pièce avec la plaque adaptatrice (4), par exemple de manière à former une seule pièce avec une douille à chasser (16), qui est chassée dans la plaque adaptatrice (4).

14. Procédé de test d'une fiche (6) comportant au moins une broche (8) pour constater le verrouillage correct, procédé comprenant au moins les étapes suivantes :
Insertion de la fiche à tester (6) dans un contour (5) sur la face supérieure d'une plaque adaptatrice (4) d'un dispositif de test (1),
Fixation de la fiche (6) dans la plaque adaptatrice (4),
Déplacement d'un plan (2) avec des sondes de test (10) en direction de la plaque adaptatrice (4), le nombre de sondes de test (10) reçues dans le plan déplaçable (2) correspondant au nombre de broches (8) à tester,
Pose des pointes d'aiguilles de test (14a) des sondes de test (10) contre les broches (8) en formant respectivement un premier point de mesure, pose des surfaces d'appui avant (12a) des pistons de support (12) des sondes de test (10) contre le boîtier (7) de la fiche (6) et mesure ou détermination du déplacement relatif des aiguilles de test (14) par rapport aux pistons de support (12).

15. Procédé suivant la revendication 14, **caractérisé en ce que** le déplacement relatif des aiguilles de test (14) par rapport aux pistons de support (12) est mesuré directement et **en ce qu'**un premier point de mesure est formé par la pose du piston de support (12) contre le côté face de la fiche et **en ce qu'**un second point de mesure est formé par la pose de l'aiguille de test contre la broche de la fiche et que le déplacement relatif des aiguilles de test (14) par rapport au pistons de support (12) est déterminé comme différence des deux points de mesure.
